# EUROPEAN PATENT SPECIFICATION

(11) **EP 1 633 526 B1**
(45) Date of publication and mention of the grant of the patent: **03.04.2013**
(21) Application number: 04750649.8
(22) Date of filing: 26.04.2004
(51) Int. Cl.: B24B 1/00

(54) **SYSTEMS AND METHODS FOR MECHANICAL AND/OR CHEMICAL-MECHANICAL POLISHING OF MICROFEATURE WORKPIECES**
SYSTEME UND VERFAHREN ZUM MECHANISCHEN UND/ODER CHEMISCH-MECHANISCHEN POLIEREN VON WERKSTÜCKEN MIT MIKROMERKMALEN
SYSTEMES ET PROCEDES DE POLISSAGE MECANIQUE ET/OU CHIMIOMECANIQUE DE PIECES DE MICROTRAITS

(30) Priority: 28.04.2003 US 425252
(43) Date of publication of application: 15.03.2006
(73) Proprietor: Micron Technology, Inc., Boise, ID 83706-9632 (US)
(72) Inventor: ELLEDGE, Jason B., Eagle, Idaho 83616 (US)
(74) Representative: Klunker . Schmitt-Nilson . Hirsch
(86) International application number: PCT/US2004/012765
(87) International publication number: WO 2004/098829

(56) References cited:
- WO-A-2004/067228
- US-A- 5 720 845
- US-A1- 2002 052 052
- US-B1- 6 325 696

## Description

### TECHNICAL FIELD

The present invention relates to a system and a method for polishing microfeature workpieces. In particular, the present invention relates to mechanical and/or chemical-mechanical polishing of microfeature workpieces with workpiece carrier assemblies that include piezoelectric members.

US 6 325 696 B1 discloses a chemical-mechanical polishing control system controls distribution of pressure across the backside of a semiconductor wafer being polished. The system includes a polishing apparatus having a carrier for supporting a semiconductor wafer. The carrier includes a plurality of dual function piezoelectric actuators. The actuators sense pressure variations across the semiconductor wafer and are individually controllable. A control is connected to the actuators for monitoring sensed pressure variations and controlling the actuators to provide a controlled pressure distribution across the semiconductor wafer.

### BACKGROUND

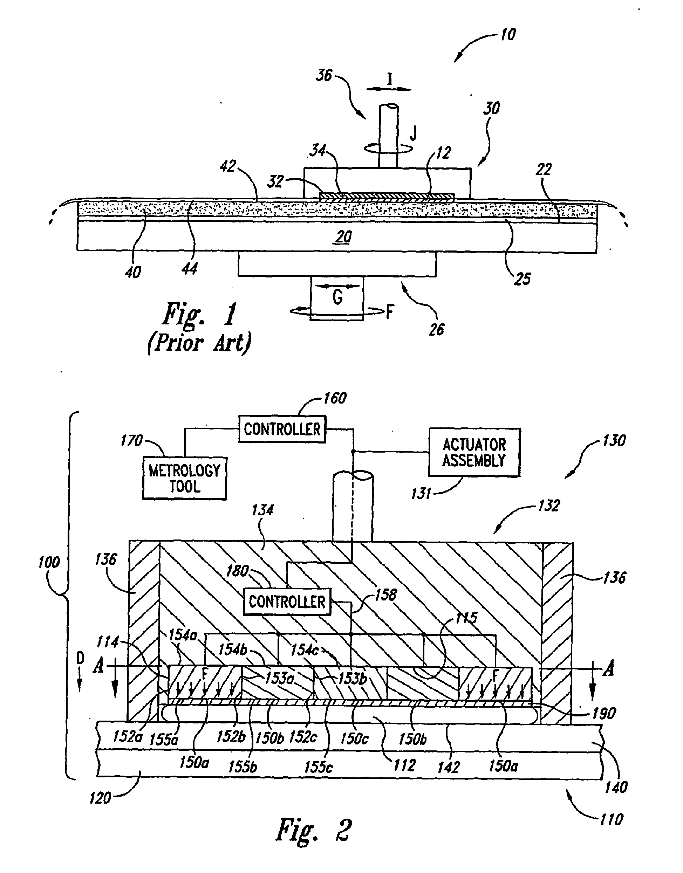

Mechanical and chemical-mechanical planarization processes (collectively, "CMP") remove material from the surface of microfeature workpieces in the production of microelectronic devices and other products. Figure 1 schematically illustrates a rotary CMP machine 10 with a platen 20, a carrier head 30, and a planarizing pad 40. The CMP machine 10 may also have an under-pad 25 between an upper surface 22 of the platen 20 and a lower surface of the planarizing pad 40. A drive assembly 26 rotates the platen 20 (indicated by arrow F) and/or reciprocates the platen 20 back and forth (indicated by arrow G). Since the planarizing pad 40 is attached to the under-pad 25, the planarizing pad 40 moves with the platen 20 during planarization.

The carrier head 30 has a lower surface 32 to which a microfeature workpiece 12 may be attached, or the workpiece 12 may be attached to a resilient pad 34 under the lower surface 32. The carrier head 30 may be a weighted, free- floating wafer carrier, or an actuator assembly 36 may be attached to the carrier head 30 to impart rotational motion to the microfeature workpiece 12 (indicated by arrow J) and/or reciprocate the workpiece 12 back and forth (indicated by arrow I).

The planarizing pad 40 and a planarizing solution 44 define a planarizing medium that mechanically and/or chemically-mechanically removes material from the surface of the microfeature workpiece 12. The planarizing solution 44 may be a conventional CMP slurry with abrasive particles and chemicals that etch and/or oxidize the surface of the microfeature workpiece 12, or the planarizing solution 44 may be a "clean" nonabrasive planarizing solution without abrasive particles. In most CMP applications, abrasive slurries with abrasive particles are used on nonabrasive polishing pads, and clean nonabrasive solutions without abrasive particles are used on fixed-abrasive polishing pads.

To planarize the microfeature workpiece 12 with the CMP machine 10, the carrier head 30 presses the workpiece 12 facedown against the planarizing pad 40. More specifically, the carrier head 30 generally presses the microfeature workpiece 12 against the planarizing solution 44 on a planarizing surface 42 of the planarizing pad 40, and the platen 20 and/or the carrier head 30 moves to rub the workpiece 12 against the planarizing surface 42. As the microfeature workpiece 12 rubs against the planarizing surface 42, the planarizing medium removes material from the face of the workpiece 12.

The CMP process must consistently and accurately produce a uniformly planar surface on the workpiece to enable precise fabrication of circuits and photo-patterns. A nonuniform surface can result, for example, when material from one area of the workpiece is removed more quickly than material from another area during CMP processing. To compensate for the nonuniform removal of material, carrier heads have been developed with expandable interior and exterior bladders that exert downward forces on selected areas of the workpiece. These carrier heads, however, have several drawbacks. For example, the typical bladder has a curved edge that makes it difficult to exert a uniform downward force at the perimeter. Moreover, conventional bladders cover a fairly broad area of the workpiece, thus limiting the ability to localize the downward force on the workpiece. Furthermore, conventional bladders are often filled with compressible air that inhibits precise control of the downward force. In addition, carrier heads with multiple bladders form a complex system that is subject to significant downtime for repair and/or maintenance, causing a concomitant reduction in throughput.

### BRIEF DESCRIPTION OF THE DRAWINGS

Figure 1 is a schematic cross-sectional side view of a portion of a rotary planarizing machine in accordance with the prior art.

Figure 2 is a schematic cross-sectional view of a system for polishing a microfeature workpiece in accordance with one embodiment of the invention.

Figure 3 is a schematic cross-sectional view taken substantially along line A-A of Figure 2.

Figure 4A is a schematic top planform view of a plurality of piezoelectric members arranged concentrically in accordance with an additional embodiment of the invention.

Figure 4B is a schematic top planform view of a plurality of piezoelectric members arranged in a grid in accordance with an additional embodiment of the invention.

### DETAILED DESCRIPTION

### A. Overview

The present invention is directed to methods and systems for mechanical and/or chemical-mechanical polishing of microfeature workpieces. The term "microfeature workpiece" is used throughout to include substrates in or on which microelectronic devices, micro-mechanical devices, data storage elements, and other features are fabricated. For example, microfeature workpieces can be semiconductor wafers, glass substrates, insulated substrates, or many other types of substrates. Furthermore, the terms "planarization" and "planarizing" mean either forming a planar surface and/or forming a smooth surface (e.g., "polishing"). Several specific details of the invention are set forth in the following description and in Figures 2-4B to provide a thorough understanding of certain embodiments of the invention.

One aspect of the invention is directed to a method for polishing a microfeature workpiece having the features of claim 1. In one embodiment, the method includes determining a status of the characteristic of the microfeature workpiece separate from the polishing cycle and moving a carrier head and/or a polishing pad relative to the other to rub the microfeature workpiece against the polishing pad after determining the status of the characteristic of the microfeature workpiece. The carrier head also carries a plurality of piezoelectric members. The method further includes applying pressure against a back side of the microfeature workpiece in response to the determined status of the characteristic by energizing at least one of the piezoelectric members. Determining the status of the characteristic can include determining a surface contour or a thickness of a layer of the microfeature workpiece, and the status of the characteristic can be determined with a metrology tool. The piezoelectric members can be arranged in a grid, concentrically, or in another pattern in the carrier head.

In another aspect of this embodiment, the status is a first status and the workpiece is a first workpiece. In this aspect, the method further includes determining a second status of the characteristic of the first microfeature workpiece after applying pressure against the first microfeature workpiece and determining a first status of the characteristic of a second microfeature workpiece. The second microfeature workpiece is different than the first microfeature workpiece. The method further includes moving the carrier head and/or the polishing pad relative to the other to rub the second microfeature workpiece against the polishing pad after determining the first status of the characteristic of the second microfeature workpiece. As the workpiece rubs against the pad, pressure is applied against a back side of the second microfeature workpiece by energizing at least one of the piezoelectric members in response to the determined first status of the characteristic of the second microfeature workpiece and the difference between a desired status and the determined second status of the characteristic of the first microfeature workpiece.

Another aspect of the invention is directed to a system for polishing a microfeature workpiece having the features of claim 17. In one embodiment, the system includes a workpiece carrier assembly configured to carry the microfeature workpiece, a plurality of piezoelectric members carried by the workpiece carrier assembly, a polishing pad positionable under the workpiece carrier assembly for polishing the microfeature workpiece, a tool for determining a status of the characteristic of the microfeature workpiece, and a controller operably coupled to the workpiece carrier assembly, the piezoelectric members, the polishing pad, and the tool. The controller has a computer-readable medium containing instructions to perform the method of claim 1.

### B. Polishing Systems

Figure 2 is a schematic cross-sectional view of a system 100 for polishing a microfeature workpiece 112 in accordance with one embodiment of the invention. The system 100 includes a CMP machine 110 (a portion of which is shown), a controller 160 (shown schematically) operably coupled to the CMP machine 110, and a metrology tool 170 (shown schematically) operably coupled to the controller 160. In the system 100, the metrology tool 170 determines the thickness of film(s) on the workpiece 112 or another characteristic of the workpiece 112. The metrology tool 170 transmits the data to the controller 160, which uses the data to control the CMP machine 110 during polishing of the workpiece 112.

In the embodiment shown in Figure 2, the CMP machine 110 includes a platen 120, a workpiece carrier assembly 130 over the platen 120, and a planarizing pad 140 coupled to the platen 120. The workpiece carrier assembly 130 can be coupled to an actuator assembly 131 (shown schematically) to move the workpiece 112 across a planarizing surface 142 of the planarizing pad 140. In the illustrated embodiment, the workpiece carrier assembly 130 includes a head 132 having a support member 134 and a retaining ring 136 coupled to the support member 134. The support member 134 can be an annular housing having an upper plate coupled to the actuator assembly 131. The retaining ring 136 extends around the support member 134 and projects toward the workpiece 112 below a bottom rim of the support member 134.

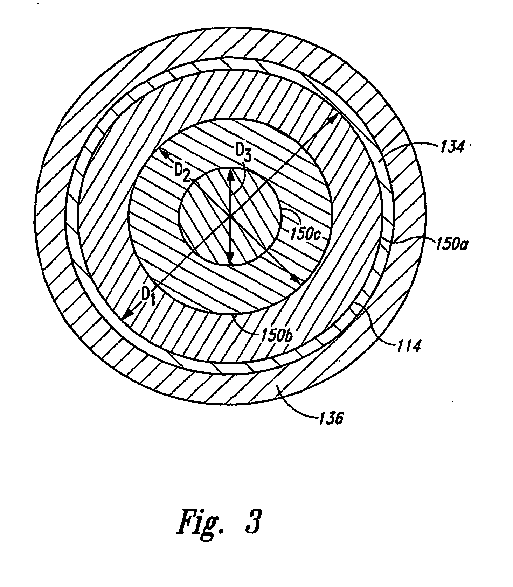

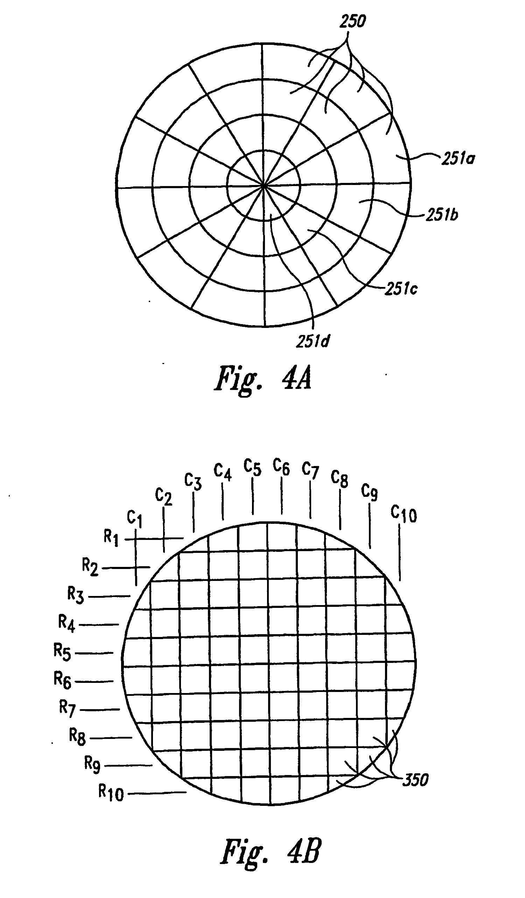

In one aspect of this embodiment, the workpiece carrier assembly 130 includes a chamber 114 in the head 132 and a plurality of piezoelectric members 150 (identified individually as 150a-c) in the chamber 114. Figure 3 is a schematic cross-sectional view taken substantially along line A-A of Figure 2. Referring to Figures 2 and 3, in the illustrated embodiment, the piezoelectric members 150 are arranged concentrically within the chamber 114. For example, a first piezoelectric member 150a has an outer diameter D₁ (Figure 3) at least approximately equal to the inner diameter of the chamber 114, a second piezoelectric member 150b has an outer diameter D₂ (Figure 3) at least approximately equal to the inner diameter of the first piezoelectric member 150a, and a third piezoelectric member 150c has an outer diameter D₃ (Figure 3) at least approximately equal to the inner diameter of the second piezoelectric member 150b. In other embodiments, the piezoelectric members 150 can be spaced apart from each other. For example, the outer diameter D₂ of the second piezoelectric member 150b can be less than the inner diameter of the first piezoelectric member 150a. In additional embodiments, such as those described below with reference to Figures 4A and 4B, the piezoelectric members may have different shapes and/or configurations.

Referring to Figure 2, in the illustrated embodiment, the piezoelectric members 150 have an outer wall 152 (identified individually as 152a-c), an inner wall 153 (identified individually as 153a-b) opposite the outer wall 152, an upper wall 154 (identified individually as 154a-c), and a lower wall 155 (identified individually as 155a-c) opposite the upper wall 154. The head 132 has a surface 115 that abuts the upper wall 154 of the piezoelectric members 150. Accordingly, when the piezoelectric members 150 are energized, the members 150 expand downwardly away from the surface 115 in the direction D. The expansion of the piezoelectric members 150 exerts a force against the workpiece 112. For example, in Figure 2, the first piezoelectric member 150a is energized and exerts a force F against a perimeter region of the workpiece 112. In additional embodiments, the piezoelectric members 150 can be energized together or individually.

The workpiece carrier assembly 130 further includes a controller 180 operably coupled to the piezoelectric members 150 to selectively energize one or more of the piezoelectric members 150. More specifically, the controller 180 can provide a voltage to the piezoelectric members 150 through an electrical coupler 158. The electrical coupler 158 can include small wires that are attached to the piezoelectric members 150. The controller 180 accordingly controls the position and magnitude of the force F by selecting the piezoelectric member(s) 150 to energize and varying the voltage. In one embodiment, the controller 180 can include an IC controller chip and a telematics controller to receive wireless signals from the controller 160. In other embodiments, the controllers 160 and 180 can communicate through wired, infrared, radio frequency, or other methods. In additional embodiments, the controller 160 can operate the piezoelectric members 150 directly without interfacing with the controller 180.

The workpiece carrier assembly 130 can further include a flexible member 190 that encloses the chamber 114 and separates the lower wall 154 of the piezoelectric members 150 from the workpiece 112. The flexible member 190 can be silicone or any other suitable material that protects the piezoelectric members 150 during polishing and prevents the planarizing solution 42 (Figure 1) from entering the chamber 114. In other embodiments, the head 132 can include additional membranes between the piezoelectric members 150 and the workpiece 112.

The metrology tool 170 measures the status of a characteristic of the workpiece 112 before polishing so the data can be used to provide a planar surface on the workpiece 112 during polishing. For example, the metrology tool 170 can measure the thickness of a layer of the workpiece 112 at several sites. After determining the status of the characteristic of the workpiece 112, the metrology tool 170 provides the data to the controller 160. The controller 160 can be an automated process controller that uses the data in controlling the polishing cycle. More specifically, the controller 160 can use the data to determine the position and strength of the forces required to provide a generally planar surface on the workpiece 112. For example, if the metrology tool 170 determines that a layer at a perimeter region of the workpiece 112 has a greater thickness than at a center region of the workpiece 112, the controller 180 can energize the first piezoelectric member 150a to exert the force F against the perimeter region of the workpiece 112 during polishing. The metrology tool 170 can determine the status of the characteristic before and/or after the workpiece 112 is attached to the workpiece carrier assembly 130. Suitable devices include metrology tools manufactured by Nova Measuring Instruments Ltd. of Israel and other similar devices. In additional embodiments, tools other than metrology tools can be used to determine the status of a characteristic.

In one aspect of this embodiment, the metrology tool 170 also determines the status of the characteristic of the workpiece 112 after polishing. Measuring the status of the characteristic after polishing allows the controller 160 to determine if the post-polishing status of the characteristic is the desired status. For example, the controller 160 can determine if the surface of the workpiece 112 is sufficiently planar and/or if a layer of the workpiece 112 has a desired thickness. Moreover, measuring the status of the characteristic after polishing allows the controller 160 to track the wear of the retaining ring 136, the planarizing pad 140, a conditioning stone (not shown), and/or other components of the CMP machine 110. For example, the controller 160 can track the wear of the CMP machine 110 by determining the difference between a projected status of the characteristic and the determined status of the characteristic of a workpiece at the end of the polishing cycle. The wear of the CMP machine 110 affects the polishing of the workpiece and consequently there can be a difference between the projected and determined statuses of the characteristic of the workpiece at the end of the polishing cycle. Accordingly, tracking the difference between the projected and determined statuses over a series of workpieces allows the controller 160 to determine wear in the CMP machine 110.

The controller 160 can adjust the polishing parameters, including the applied forces, when polishing subsequent workpieces, based on the difference between the projected status and the determined status of the characteristic of the previous workpiece to compensate for wear in the CMP machine 110 or other factors. For example, if after polishing the thickness of a layer of a workpiece is greater than the projected thickness, the controller 160 can adjust the applied forces, the dwell time, or other polishing parameters to increase the material removed from subsequent workpieces. In additional embodiments, the system 100 may not include a metrology tool 170 and the controller 160 can adjust the polishing parameters, including the applied forces, based upon an expected status of the characteristic of the workpiece 112. In other embodiments, the system 100 can include a sensor to monitor the planarity of the workpiece surface during polishing. In such embodiments, the controller 160 can adjust the polishing parameters, including the applied forces, based upon the monitored planarity of the workpiece.

### C. Other Configurations of Piezoelectric Members

Figures 4A and 4B are schematic top planform views of several configurations of piezoelectric members for use with workpiece carrier assemblies in accordance with additional embodiments of the invention. For example, Figure 4A illustrates a plurality of arcuate piezoelectric members 250 arranged generally concentrically in a plurality of rings 251 (identified individually as 251 a-d). Each ring 251 is divided into generally equally sized piezoelectric members 250. In other embodiments, the piezoelectric members 250 can be arranged differently. For example, each piezoelectric member can be spaced apart from the other piezoelectric members.

Figure 4B is a schematic top planform view of a plurality of piezoelectric members 350 in accordance with another embodiment of the invention. The piezoelectric members 350 are arranged in a grid with a plurality of rows R₁-R₁₀ and a plurality of columns C₁-C₁₀. In the illustrated embodiment, the piezoelectric members 350 proximate to the perimeter have a curved side corresponding to the curvature of the chamber 114 (Figure 2) in the workpiece carrier assembly 130 (Figure 2). In additional embodiments, the size of each piezoelectric member can decrease to increase the resolution. In other embodiments, the piezoelectric members can be arranged in other configurations, such as in quadrants or in a single circle.

One advantage of the polishing systems of the illustrated embodiments is the ability to apply highly localized forces to a workpiece in response to a predetermined characteristic of the workpiece. This highly localized force control enables the CMP process to consistently and accurately produce a uniformly planar surface on the workpiece. Moreover, the system can also adjust the applied forces and polishing parameters to account for wear of the CMP machine. Another advantage of the illustrated workpiece carrier assemblies is that they are simpler than existing systems and, consequently, reduce downtime for maintenance and/or repair and create greater throughput.

From the foregoing, it will be appreciated that specific embodiments of the invention have been described herein for purposes of illustration, but that various modifications may be made without deviating from the spirit and scope of the invention. Accordingly, the invention is not limited except as by the appended claims.

## Claims

1. A method for polishing a microfeature workpiece having a characteristic, the method comprising:
determining a first status of the characteristic of the microfeature workpiece separate from the polishing cycle;
moving at least one of a carrier head and a planarizing medium relative to the other with the microfeature workpiece in the carrier head to rub the microfeature workpiece against the planarizing medium after determining the first status of the characteristic of the microfeature workpiece, the carrier head carrying a plurality of driving members;
applying pressure against a back side of the microfeature workpiece in response to the determined first status of the characteristic by controlling at least one of the plurality of driving members;
determining a second status of the characteristic of the microfeature workpiece after applying pressure against the microfeature workpiece;
tracking the difference between a desired status of the characteristic after planarizing the workpiece and the second status of the characteristic of the microfeature workpiece to determine wear in at least one of the planarizing medium, the carrier head, or a conditioning stone; and
adjusting the polishing parameters including the applied forces based on the difference between a desired status of the characteristic after planarizing the workpiece and the second status of the characteristic of the microfeature workpiece to compensate for the wear.

2. The method of claim 1 wherein:
the driving members comprise a plurality of piezoelectric members; and
applying pressure against the back side of the workpiece comprises providing the desired status of the characteristic in a region of the microfeature workpiece by energizing at least one of the plurality of piezoelectric members based on the determined status of the characteristic.

3. The method of claim 2 wherein providing the desired status of the characteristic comprises energizing at least one of the plurality of piezoelectric members based on a predetermined wear of at least one of the carrier head, the planarizing medium, and a conditioning stone.

4. The method of claim 1, further comprising:
arranging the plurality of driving members based on the determined status of the characteristic;
monitoring the planarity of a surface of the microfeature workpiece during the polishing cycle; and
rearranging at least some of the plurality of driving members based on the monitored planarity of the surface of the microfeature workpiece during the polishing cycle.

5. The method of claim 1, further comprising:
arranging the plurality of driving members based on an estimated surface contour;
monitoring the planarity of a surface of the microfeature workpiece during the polishing cycle; and
rearranging at least some of the plurality of driving members based on the monitored planarity of the surface of the microfeature workpiece during the polishing cycle.

6. The method of any of the claims 1 to 5, wherein determining the first status of the characteristic comprises determining a surface contour of the microfeature workpiece.

7. The method of any of the claims 1 to 5, wherein determining the first status of the characteristic comprises determining a thickness of a layer of the microfeature workpiece.

8. The method of any of the claims 1 to 5, wherein determining the first status of the characteristic comprises determining the status of the characteristic with a metrology tool.

9. The method of any of the claims 1 to 5, wherein the microfeature workpiece comprises a first microfeature workpiece, and wherein the method further comprises:
determining a first status of the characteristic of a second microfeature workpiece, the second microfeature workpiece being different than the first microfeature workpiece;
moving at least one of the carrier head and the planarizing medium relative to the other after determining the first status of the characteristic of the second microfeature workpiece; and
applying pressure against a back side of the second microfeature workpiece by controlling at least one of the plurality of driving members in response to the determined first status of the characteristic of the second microfeature workpiece and the difference between a desired status and the determined second status of the characteristic of the first microfeature workpiece.

10. The method of claim 1 wherein applying pressure against the microfeature workpiece comprises applying pressure against the workpiece to provide a desired status of the characteristic of the workpiece.

11. The method of any of the claims 1 to 5, wherein:
determining the first status of the characteristic comprises determining the first status of the characteristic in a first region; and
applying pressure against the microfeature workpiece comprises applying pressure against the back side of the microfeature workpiece in the first region. -

12. The method of any of the claims 1 to 5, wherein the plurality of driving members are arranged concentrically, and wherein applying pressure against the microfeature workpiece comprises controlling at least one of the concentrically arranged driving members.

13. The method of any of the claims 1 to 5, wherein the plurality of driving members are arranged in a grid, and wherein applying pressure against the microfeature workpiece comprises controlling at least one of the driving members arranged in the grid.

14. The method of any of the claims 1 to 5, wherein:
determining the first status of the characteristic comprises determining a thick area and a thin area on the microfeature workpiece; and
applying pressure against the back side comprises applying a first pressure at the thick area of the microfeature workpiece and a second pressure at the thin area of the microfeature workpiece, wherein the second pressure is different than the first pressure.

15. The method of any of the claims 1 to 5, wherein applying pressure against the back side comprises:
arranging the at least one driving member in a first position to exert a first pressure against the back side of the microfeature workpiece; and
moving the at least one driving member from the first position to a second position to exert a second pressure against the back side of the microfeature workpiece.

16. The method of claim 1 wherein the driving members comprise a plurality of piezoelectric members, and wherein controlling at least one of the driving members comprises energizing at least one of the piezoelectric members.

17. A system for polishing a microfeature workpiece having a characteristic and a back side, the system comprising:
a workpiece carrier assembly configured to carry the microfeature workpiece;
a plurality of driving members carried by the workpiece carrier assembly;
a planarizing medium positionable under the workpiece carrier assembly for polishing the microfeature workpiece;
a tool for determining a status of the characteristic of the microfeature workpiece; and
a controller operably coupled to the workpiece carrier assembly, the plurality of driving members, the planarizing medium, and the tool, the controller having a computer-readable medium containing instructions to perform a method comprising:
determining a first status of the characteristic of the microfeature workpiece separate from a polishing cycle;
moving at least one of the workpiece carrier assembly and the planarizing medium relative to the other with the microfeature workpiece in the carrier head to rub the microfeature workpiece against the planarizing medium during a polishing cycle after determining the first status of the characteristic of the microfeature workpiece;
applying pressure against the back side of the microfeature workpiece during a portion of the polishing cycle in response to the determined first status of the characteristic by controlling at least one of the plurality of driving members;
determining a second status of the characteristic of the microfeature workpiece after applying pressure against the microfeature workpiece;
tracking the difference between a desired status for after the polishing cycle and the second status of the characteristic of the microfeature workpiece to determine wear in at least one of the carrier assembly, the planarizing medium, or a conditioning stone; and
adjusting the polishing parameters including the applied forces based on the difference between a desired status of the characteristic after the polishing cycle and the second status of,the characteristic of the microfeature workpiece to compensate for the wear.

18. The system of claim 17 wherein the plurality of driving members are arranged in a grid in the workpiece carrier assembly.

19. The system of claim 17 wherein the plurality of driving members are arranged concentrically in the workpiece carrier assembly.

20. The system of claim 17 wherein the tool is configured to determine the first status of the characteristic of the microfeature workpiece when the microfeature workpiece is carried by the workpiece carrier assembly.

21. The system of claim 17 wherein the tool is configured to determine the first status of the characteristic of the microfeature workpiece before and/or after the microfeature workpiece is carried by the workpiece carrier assembly.

22. The system of claim 17 wherein the tool is configured to determine a thickness of a layer of the microfeature workpiece.

23. The system of claim 17 wherein the tool is configured to determine a surface contour of the microfeature workpiece.

24. The system of claim 17 wherein the plurality of driving members comprise a plurality of piezoelectric members.

## Patentansprüche

1. Verfahren zum Polieren eines Werkstücks mit Mikromerkmalen, das eine charakteristische Eigenschaft hat, wobei das Verfahren einschließt:
Bestimmen eines ersten Zustandes der charakteristischen Eigenschaft des Werkstücks mit Mikromerkmalen unabhängig vom Polierzyklus;
Bewegen von wenigstens einem von einem Trägerkopf und einem Glättungsmittel in Bezug auf das andere, wobei das Werkstück mit Mikromerkmalen im Trägerkopf angeordnet ist, um das Werkstück mit Mikromerkmalen an dem Glättungsmittel zu reiben, nachdem der erste Zustand der charakteristischen Eigenschaft des Werkstücks mit Mikromerkmalen bestimmt worden ist, wobei der Trägerkopf mehrere Antriebselemente trägt;
Aufbringen von Druck auf die Rückseite des Werkstücks mit Mikromerkmalen in Reaktion auf den bestimmten ersten Zustand der charakteristischen Eigenschaft durch Ansteuern wenigstens eines der mehreren Antriebselemente;
Bestimmen eines zweiten Zustandes der charakteristischen Eigenschaft des Werkstücks mit Mikromerkmalen nach dem Aufbringen des Drucks auf das Werkstück mit den Mikromerkmalen;
Verfolgen der Differenz zwischen einem gewünschten Zustand der charakteristischen Eigenschaft nach dem Glätten des Werkstücks und dem zweiten Zustand der Eigenschaft des Werkstücks mit Mikromerkmalen, um eine Abnutzung von wenigstens einem von dem Glättungsmittel, dem Trägerkopf und einem Bearbeitungsstein zu bestimmen; und
Anpassen der Polierparameter einschließlich der aufgebrachten Kräfte basierend auf der Differenz zwischen einem gewünschten Status der charakteristischen Eigenschaft nach dem Glätten des Werkstücks und dem zweiten Zustand der charakteristischen Eigenschaft des Werkstücks mit Mikromerkmalen, um die Abnutzung auszugleichen.

2. Verfahren nach Anspruch 1, wobei
die Antriebselemente mehrere piezoelektrische Elemente aufweisen; und
das Aufbringen von Druck auf die Rückseite des Werkstücks einschließt, den gewünschten Zustand der Eigenschaft in einem Bereich des Werkstücks mit Mikromerkmalen durch Antreiben wenigstens eines der mehreren piezoelektrischen Elemente basierend auf dem bestimmten Zustand der charakteristischen Eigenschaft zu schaffen.

3. Verfahren nach Anspruch 2, wobei das Bereitstellen des gewünschten Zustandes der charakteristischen Eigenschaft einschließt, wenigstens eines der mehreren piezoelektrischen Elemente basierend auf einer vorgegebenen Abnutzung von wenigstens einem von dem Trägerkopf, dem Glättungsmittel und einem Bearbeitungsstein anzutreiben.

4. Verfahren nach Anspruch 1, zusätzlich aufweisend:
Anordnen der mehreren Antriebselemente basierend auf dem bestimmten Zustand der charakteristischen Eigenschaft;
Überwachen der Glattheit einer Fläche des Werkstücks mit Mikromerkmalen während des Polierzyklus; und
erneutes Ausrichten wenigstens eines der mehreren Antriebselemente basierend auf der überwachten Glattheit der Oberfläche des Werkstücks mit Mikromerkmalen während des Polierzyklus.

5. Verfahren nach Anspruch 1, zusätzlich aufweisend:
Ausrichten der mehreren Antriebselemente basierend auf einer geschätzten Oberflächenkontur;
Beobachten der Glattheit einer Oberfläche des Werkstücks mit Mikromerkmalen während des Polierzyklus; und
erneutes Ausrichten wenigstens einiger der mehreren Antriebselemente basierend auf einer beobachteten Glattheit der Oberfläche des Werkstücks mit Mikromerkmalen während des Polierzyklus.

6. Verfahren nach einem der Ansprüche 1 bis 5, wobei das Bestimmen des ersten Zustands der charakteristischen Eigenschaft einschließt, eine Oberflächenkontur des Werkstücks mit Mikromerkmalen zu bestimmen.

7. Verfahren nach einem der Ansprüche 1 bis 5, wobei das Bestimmen eines ersten Zustandes der charakteristischen Eigenschaft einschließt, eine Dicke einer Schicht des Werkstücks mit Mikromerkmalen zu bestimmen.

8. Verfahren nach einem der Ansprüche 1 bis 5, wobei das Bestimmen des ersten Zustandes der charakteristischen Eigenschaft einschließt, den Status der charakteristischen Eigenschaft mit einem Messwerkzeug zu bestimmen.

9. Verfahren nach einem der Ansprüche 1 bis 5, wobei das Werkstück mit Mikromerkmalen ein erstes Werkstück mit Mikromerkmalen umfasst, und wo dabei das Verfahren zusätzlich einschließt:
Bestimmen eines ersten Zustandes der Eigenschaft eines zweiten Werkstücks mit Mikromerkmalen, wobei sich das zweite Werkstück mit Mikromerkmalen von dem ersten Werkstück mit Mikromerkmalen unterscheidet;
Bewegen wenigstens eines von dem Trägerkopf und dem Glättungsmittel relativ zu dem anderen nach dem Bestimmen des ersten Zustandes der charakteristischen Eigenschaft des zweiten Werkstücks mit Mikromerkmalen; und
Aufbringen von Druck auf die Rückseite des zweiten Werkstücks mit Mikromerkmalen durch Ansteuern wenigstens eines von mehreren Antriebselementen in Reaktion auf den bestimmten ersten Zustand der charakteristischen Eigenschaft des zweiten Werkstücks mit Mikromerkmalen und der Differenz zwischen einem gewünschten Zustand und dem bestimmten zweiten Zustand der charakteristischen Eigenschaft des ersten Werkstücks mit Mikromerkmalen.

10. Verfahren nach Anspruch 1, wobei das Aufbringen von Druck auf die Rückseite des Werkstücks mit Mikromerkmalen einschließt, Druck auf das Werkstück auszuüben, um einen gewünschten Zustand der charakteristischen Eigenschaft des Werkstücks zu schaffen.

11. Verfahren nach einem der Ansprüche 1 bis 5, wobei:
das Bestimmen des ersten Zustandes der charakteristischen Eigenschaft einschließt, den ersten Zustand der charakteristischen Eigenschaft in einem ersten Bereich zu bestimmen; und
das Aufbringen von Druck auf das Werkstück mit Mikromerkmalen einschließt, im ersten Bereich Druck auf die Rückseite des Werkstücks mit Mikromerkmalen auszuüben.

12. Verfahren nach einem der Ansprüche 1 bis 5, wobei die mehreren Antriebselemente konzentrisch angeordnet sind und wobei das Aufbringen von Druck auf das Werkstück mit Mikromerkmalen einschließt, wenigstens eines der konzentrisch angeordneten Antriebselemente anzusteuern.

13. Verfahren nach einem der Ansprüche 1 bis 5, wobei die mehreren Antriebselemente in einem Gitter angeordnet sind und wobei das Ausüben von Druck auf das Werkstück mit Mikromerkmalen einschließt, wenigstens eines der im Gitter angeordneten Antriebselemente anzusteuern.

14. Verfahren nach einem der Ansprüche 1 bis 5, wobei:
das Bestimmen eines ersten Zustandes der charakteristischen Eigenschaft einschließt, auf dem Werkstück mit Mikromerkmalen einen dicken Bereich und einen dünnen Bereich zu bestimmen; und
das Ausüben von Druck auf die Rückseite einschließt, einen ersten Druck auf den dicken Bereich des Werkstücks mit Mikromerkmalen auszuüben und einen zweiten Druck auf den dünnen Bereich des Werkstücks mit Mikromerkmalen auszuüben, wobei sich der zweite Druck von dem ersten Druck unterscheidet.

15. Verfahren nach einem der Ansprüche 1 bis 5, wobei das Ausüben von Druck auf die Rückseite einschließt,
Anordnen des wenigstens einen Antriebselements an einer ersten Position, um einen ersten Druck auf die Rückseite des Werkstücks mit Mikromerkmalen auszuüben; und
Bewegen des wenigstens einen Antriebselements von der ersten Position an eine zweite Position, um einen zweiten Druck auf die Rückseite des Werkstücks mit Mikromerkmalen auszuüben.

16. Verfahren nach Anspruch 1, wobei die Antriebselemente mehrere piezoelektrische Elemente aufweisen, und wobei das Ansteuern wenigstens eines Antriebselements einschließt, wenigstens eines der piezoelektrischen Elemente mit Energie zu versorgen.

17. System zum Polieren eines Werkstücks mit Mikromerkmalen, das eine charakteristische Eigenschaft und eine Rückseite hat, wobei das System aufweist:
eine Werkstückträgeranordnung, die eingerichtet ist, das Werkstück mit Mikromerkmalen zu tragen;
mehrere Antriebselemente, die von der Werkstückanordnung getragen werden;
ein Glättungsmittel, das unter der Werkstückträgeranordnung positionierbar ist, um das Werkstück mit Mikromerkmalen zu polieren;
ein Werkzeug, um einen Zustand der Eigenschaft des Werkstücks mit Mikromerkmalen zu bestimmen; und
eine Steuerung, die betriebsmäßig mit der Werkstückträgeranordnung, den mehreren Antriebselementen, dem Glättungsmittel und dem Werkzeug gekoppelt ist, wobei die Steuerung ein computerlesbares Medium hat, das Anweisungen enthält, um ein Verfahren auszuführen, das einschließt:
Bestimmen eines ersten Zustandes der charakteristischen Eigenschaft des Werkstücks mit Mikromerkmalen unabhängig vom Polierzyklus;
Bewegen von wenigstens einem von der Werkstückträgeranordnung und dem Glättungsmittel in Bezug auf das andere, wobei das Werkstück mit den Mikroeigenschaften im Trägerkopf angeordnet ist, um das Werkstück mit Mikroeigenschaften während eines Polierzyklus an dem Glättungsmittel zu reiben, nachdem der erste Zustand der charakteristischen Eigenschaft der Werkstücks mit Mikromerkmalen bestimmt worden ist;
Aufbringen von Druck auf die Rückseite des Werkstücks mit Mikromerkmalen während eines Teils der Polierzyklus in Reaktion auf den bestimmten ersten Zustand der charakteristischen Eigenschaft durch Ansteuern wenigstens eines der mehreren Antriebselemente;
Bestimmen eines zweiten Zustandes der charakteristischen Eigenschaft des Werkstücks mit Mikromerkmalen nach dem Ausüben von Druck auf das Werkstück mit Mikromerkmalen;
Verfolgen der Differenz zwischen dem nach dem Polierzyklus gewünschten Zustand und dem zweiten Zustand der charakteristischen Eigenschaft des Werkstücks mit Mikromerkmalen, um eine Abnutzung von wenigstens einem von der Trägeranordnung, dem Glättungsmittel und einem Bearbeitungsstein zu bestimmen; und
Anpassen der Polierparameter einschließlich der aufgebrachten Kräfte basierend auf der Differenz zwischen dem gewünschten Status der charakteristischen Eigenschaft nach dem Polierzyklus und dem zweiten Zustand der charakteristischen Eigenschaft des Werkstücks mit Mikromerkmalen, um die Abnutzung auszugleichen.

18. System nach Anspruch 17, wobei die mehreren Antriebselemente gitterförmig in der Werkstückträgeranordnung angeordnet sind.

19. System nach Anspruch 17, wobei die mehreren Antriebselemente konzentrisch in der Werkstückträgeranordnung angeordnet sind.

20. System nach Anspruch 17, wobei das Werkzeug eingerichtet ist, einen ersten Zustand der charakteristischen Eigenschaft des Werkstücks mit Mikromerkmalen zu bestimmen, wenn das Werkstück mit Mikromerkmalen von der Werkstückträgeranordnung getragen wird.

21. System nach Anspruch 17, wobei das Werkzeug eingerichtet ist, den ersten Zustand einer charakteristischen Eigenschaft des Werkstücks mit Mikromerkmalen zu bestimmen, bevor und/oder nachdem das Werkstück mit Mikromerkmalen von der Werkstückträgeranordnung getragen wird.

22. System nach Anspruch 17, wobei das Werkzeug eingerichtet ist, eine Dicke einer Schicht des Werkstücks mit Mikromerkmalen zu bestimmen.

23. System nach Anspruch 17, wobei das Werkzeug eingerichtet ist, eine Oberflächenkontur des Werkstücks mit Mikromerkmalen zu bestimmen.

24. System nach Anspruch 17, wobei die mehreren Antriebselemente mehrere piezoelektrische Elemente aufweisen.

## Revendications

1. Procédé de polissage d'une pièce présentant des micro-motifs ayant une caractéristique, le procédé comprenant les étapes suivantes :
déterminer un premier état de la caractéristique de la pièce présentant des micro motifs séparément du cycle de polissage ;
déplacer au moins soit une tête support soit un support de planarisation l'un par rapport à l'autre la pièce présentant des micro motifs étant placée dans la tête support pour frotter la pièce présentant des micro motifs contre le support de planarisation après détermination du premier état de la caractéristique de la pièce présentant des micro motifs, la tête support portant une pluralité d'éléments d'entraînement ;
appliquer une pression sur la face arrière de la pièce présentant des micro motifs en réponse au premier état déterminé de la caractéristique en commandant au moins l'un de la pluralité d'éléments d'entraînement ;
déterminer un second état de la caractéristique de la pièce présentant des micro motifs après application de la pression sur la face arrière de la pièce présentant des micro motifs;
suivre la différence entre un état souhaité de la caractéristique après planarisation de la pièce et le second état de la caractéristique de la pression sur la face arrière de la pièce présentant des micro motifs pour déterminer l'usure d'au moins le support de planarisation, la tête support ou une pierre de conditionnement, et
ajuster les paramètres de polissage incluant les forces appliquées en se basant sur la différence entre un état souhaité de la caractéristique après planarisation de la pièce et le second état de la caractéristique de la pièce présentant des micro motifs pour compenser l'usure.

2. Procédé selon la revendication 1, dans lequel :
les éléments d'entraînement comprennent une pluralité d'éléments piézoélectriques ; et
appliquer une pression sur la face arrière de la pièce comprend fournir l'état souhaité de la caractéristique dans une région de la pièce présentant des micro motifs en excitant au moins l'un de la pluralité d'éléments piézoélectriques en se basant sur l'état déterminé par la caractéristique.

3. Procédé selon la revendication 2, dans lequel fournir l'état souhaité de la caractéristique comprend d'exciter au moins l'un de la pluralité d'éléments piézoélectriques sur la base d'une usure prédéterminée d'au moins soit la tête support, soit le support de planarisation soit une pierre de conditionnement.

4. Procédé selon la revendication 1, comprenant en outre les étapes suivantes :
disposer la pluralité d'éléments d'entraînement sur la base de l'état déterminé de la caractéristique ;
surveiller la planarité d'une surface de la pièce présentant des micro motifs pendant le cycle de polissage ; et
redisposer au moins quelques-uns de la pluralité d'éléments d'entraînement en se basant sur la planarité contrôlée de la surface de la pièce présentant des micro motifs pendant le cycle de polissage.

5. Procédé selon la revendication 1, comprenant en outre les étapes suivantes :
disposer la pluralité d'éléments d'entraînement sur la base d'un contour de surface estimé ;
surveiller la planarité d'une surface de la pièce présentant des micro motifs pendant le cycle de polissage ; et
redisposer au moins quelques-uns de la pluralité d'éléments d'entraînement en se basant sur planarité surveillée de la surface de la pièce présentant des micro motifs pendant le cycle de polissage.

6. Procédé selon l'une quelconque des revendications 1 à 5, dans lequel la détermination du premier état de la caractéristique comprend la détermination d'un contour de surface de la pièce présentant des micro motifs.

7. Procédé selon l'une quelconque des revendications 1 à 5, dans lequel la détermination du premier état de la caractéristique comprend la détermination d'une épaisseur d'une couche de la pièce présentant des micro motifs.

8. Procédé selon l'une quelconque des revendications 1 à 5, dans lequel la détermination du premier état de la caractéristique comprend la détermination de l'état de la caractéristique avec un outil de métrologie.

9. Procédé selon l'une quelconque des revendications 1 à 5, dans lequel la pièce présentant des micro motifs comprend une première pièce présentant des micro motifs et dans lequel le procédé comprend en outre les étapes suivantes :
déterminer un premier état de la caractéristique d'une seconde pièce présentant des micro motifs, la seconde pièce présentant des micro motifs étant différente de la première pièce présentant des micro motifs;
déplacer au moins soit la tête support soit le support de planarisation l'un par rapport à l'autre après détermination du premier état de la caractéristique de la seconde pièce présentant des micro motifs ; et
appliquer la pression sur la face arrière de la seconde pièce présentant des micro motifs en commandant au moins l'un de la pluralité d'éléments d'entraînement en réponse au premier état déterminé de la caractéristique de la seconde pièce présentant des micro motifs et en réponse à la différence entre un état souhaité et le second état déterminé de la caractéristique de la première pièce présentant des micro motifs.

10. Procédé selon la revendication 1, dans lequel l'application de la pression contre la pièce présentant des micro motifs comprend l'application de la pression contre la pièce pour être dans un état souhaité de la caractéristique de la pièce.

11. Procédé selon l'une quelconque des revendications 1 à 5, dans lequel :
la détermination du premier état de la caractéristique comprend la détermination du premier état de la caractéristique dans une première région ; et
l'application de la pression contre la pièce présentant des micro motifs comprend l'application de la pression contre la face arrière de la pièce présentant des micro motifs dans la première région.

12. Procédé selon l'une quelconque des revendications 1 à 5, dans lequel la pluralité d'éléments d'entraînement est disposée concentriquement et dans lequel l'application de la pression contre la pièce présentant des micro motifs comprend la commande d'au moins l'un des éléments d'entraînement disposés concentriquement.

13. Procédé selon l'une quelconque des revendications 1 à 5, dans lequel la pluralité d'éléments d'entraînement est disposée dans une grille et dans lequel l'application de la pression contre la pièce présentant des micro motifs comprend la commande d'au moins l'un des éléments d'entraînement disposés dans la grille.

14. Procédé selon l'une quelconque des revendications 1 à 5, dans lequel :
la détermination du premier état de la caractéristique comprend la détermination d'une zone épaisse et d'une zone fine sur la pièce présentant des micro motifs; et
l'application de la pression sur la face arrière comprend l'application d'une première pression sur la zone épaisse de la pièce de microtraits et d'une seconde pression sur la zone fine de la pièce de microtraits, la seconde pression étant différente de la première pression.

15. Procédé selon l'une quelconque des revendications 1 à 5, dans lequel l'application de la pression contre la face arrière comprend les étapes suivantes :
disposer au moins un élément d'entraînement dans une première position pour exercer une première pression contre la face arrière de la pièce présentant des micro motifs; et
déplacer l'au moins un élément d'entraînement de la première à la seconde position pour exercer une seconde pression contre la face arrière de la pièce présentant des micro motifs.

16. Procédé selon la revendication 1, dans lequel les éléments d'entraînement comprennent une pluralité d'éléments piézoélectriques, et dans lequel la commande d'au moins l'un des éléments d'entraînement comprend l'excitation d'au moins l'un des éléments piézoélectriques.

17. Système de polissage d'une pièce présentant des micro motifs présentant une caractéristique et une face arrière, le système comprenant :
un ensemble porteur de pièce configuré pour porter la pièce présentant des micro motifs;
une pluralité d'éléments d'entraînement portés par l'ensemble porteur de pièce ;
un support de planarisation positionnable sous l'ensemble porteur de pièce pour le polissage de la pièce présentant des micro motifs;
un outil pour déterminer un état de la caractéristique de la pièce présentant des micro motifs; et
un contrôleur couplé en fonctionnement à l'ensemble porteur de pièce, la pluralité d'éléments d'entraînement, le support de planarisation et l'outil, le contrôleur ayant un support lisible par ordinateur contenant des instructions pour réaliser un procédé comprenant les étapes suivantes :
déterminer un premier état de la caractéristique de la pièce présentant des micro motifs séparément du cycle de polissage ;
déplacer au moins soit l'ensemble porteur de pièce soit le support de planarisation l'un par rapport à l'autre avec la pièce présentant des micro motifs située dans la tête support pour frotter la pièce présentant des micro motifs contre le support de planarisation pendant un cycle de polissage après détermination du premier état de la caractéristique de la pièce présentant des micro motifs;
appliquer une pression sur la face arrière de la pièce présentant des micro motifs pendant une partie du cycle de polissage en réponse au premier état déterminé de la caractéristique en commandant au moins l'un de la pluralité d'éléments d'entraînement ;
déterminer un second état de la caractéristique de la pièce présentant des micro motifs après application de la pression contre la pièce présentant des micro motifs;
suivre la différence entre un état souhaité pour après le cycle de polissage et le second état de la caractéristique de la pièce présentant des micro motifs pour déterminer l'usure dans au moins l'ensemble porteur, le support de planarisation ou une pierre de conditionnement ; et
ajuster les paramètres de polissage incluant les forces appliquées sur la base de la différence entre un état souhaité de la caractéristique après le cycle de polissage et le second état de la caractéristique de la pièce présentant des micro motifs pour compenser l'usure.

18. Système selon la revendication 17, dans lequel la pluralité d'éléments d'entraînement est disposée dans une grille dans l'ensemble porteur de pièce.

19. Système selon la revendication 17, dans lequel la pluralité d'éléments d'entraînement est disposée concentriquement dans l'ensemble porteur de pièce.

20. Système selon la revendication 17, dans lequel l'outil est configuré pour déterminer le premier état de la caractéristique de la pièce présentant des micro motifs lorsque la pièce présentant des micro motifs est portée par l'ensemble porteur de pièce.

21. Système selon la revendication 17, dans lequel l'outil est configuré pour déterminer le premier état de la caractéristique de la pièce présentant des micro motifs avant et/ou après que la pièce présentant des micro motifs soit portée par l'ensemble porteur de pièce.

22. Système selon la revendication 17, dans lequel l'outil est configuré pour déterminer une épaisseur d'une couche de la pièce présentant des micro motifs.

23. Système selon la revendication 17, dans lequel l'outil est configuré pour déterminer un contour de surface de la pièce présentant des micro motifs.

24. Système selon la revendication 17, dans lequel la pluralité d'éléments d'entraînement comprend une pluralité d'éléments piézoélectriques.
